# EUROPEAN PATENT SPECIFICATION

(11) **EP 0 630 933 B1**
(45) Date of publication and mention of the grant of the patent: **14.04.1999**
(21) Application number: 94304253.1
(22) Date of filing: 13.06.1994
(51) Int. Cl.: C08G 77/60

(54) **A method of producing a semiconducting material**
Verfahren zur Herstellung eines Halbleitermaterials
Procédé de préparation d'un matériau semi-conducteur

(30) Priority: 15.06.1993 JP 168651/93
(43) Date of publication of application: 28.12.1994
(73) Proprietor: NIPPON OIL CO. LTD., Minato-ku Tokyo (JP)
(72) Inventor: Ikai, Keizo, Yokohama-shi, Kanagawa-ken (JP); Matsuno, Mitsuo, Yokohama-shi, Kanagawa-ken (JP); Minami, Masaki, Yokohama-shi, Kanagawa-ken (JP)
(74) Representative: Bridge-Butler, Alan James

(56) References cited:
- EP-A- 0 314 327
- EP-A- 0 551 771
- DE-A- 4 110 917
- FR-A- 2 701 483
- US-A- 4 478 654
- US-A- 5 229 481
- US-A- 5 252 766

## Description

This invention relates to a method of producing a semiconducting material for use in the formation of diodes, transistors, field effect transistors, thyristors and like semiconductor elements.

A gas-phase crystal growth procedure has found extensive use in the production of thin films of amorphous silicone or compound semiconductors in which their low molecular weight feedstock in gaseous phase is thermally decomposed or chemically reacted in high vacuum to deposit on a substrate. This method however would involve prohibitive costs to reduce to practice for making large semiconductor films because there will be required large-scale vacuum devices on one hand and there is a limitation imposed upon the rate of film deposition on the other.

With the foregoing drawbacks of the prior art in view, the present invention seeks to provide an improved method of producing semiconducting materials at a maximum rate of efficiency and a minimum of costs.

DE-A-4 110 917 discloses a thermal treatment for producing silicon carbide from a polysilane. The described process is concerned with the use of certain metals as catalysts using temperatures in excess of 800 degrees Celcius, 900 degrees is examplified.

JP-A-5 032 785 and US-A-5 252 760 describe a process for producing a polysilane which involves a dehydrogenative condensation by reacting a hydrosilane in the presence of an organolanthanoid complex. The reaction is carried out in solvent.

EP-A-0 551 771 describes a process for producing polysilanes by catalytic polymerization of a hydrosilane using a catalyst mixture of a metallocene compound and either a specific silyl compound or a specific metallic hydride. The process produces a higher degree of polymerization than that using previously suggested catalysts.

According to the present invention there is provided a method of producing a semiconducting material which is characterized by subjecting to hydrogenative condensation one or more hydrosilanes of the group consisting of :
a hydromonosilane of the formula 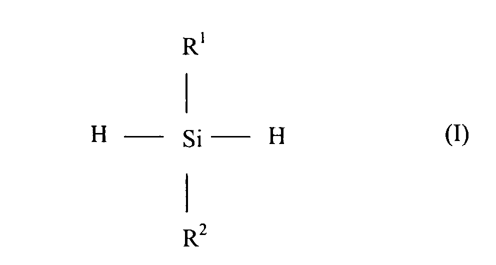 wherein R¹ and R² are independently selected from the group consisting of a hydrogen atom and alkyl, cycloalkyl and halogenated alkyl groups having from 1 to 12 carbon atoms, aralkyl groups and halogenated aralkyl groups having from 7 to 12 carbon atoms, aryl groups having 6 to 12 carbon atoms and silyl groups having the formula:

R³ R⁴ R⁵ Si- (I')

wherein R³, R⁴ and R⁵ are independently selected from the group consisting of alkyl groups having up to 8 carbon atoms and aryl groups having from 6 to 10 carbon atoms, a hydrodisilane of the formula: 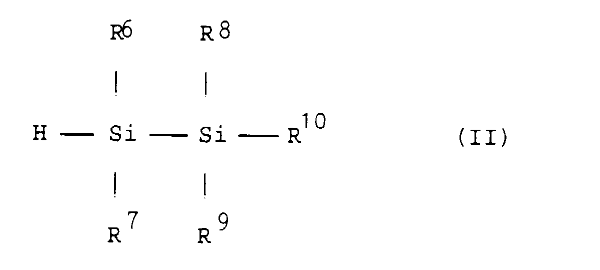 wherein R⁶ to R¹⁰ are independently selected from the group consisting of a hydrogen atom and alkyl, cycloalkyl and halogenated alkyl groups having up to 12 carbon atoms, aralkyl groups and halogenated aralkyl groups having from 7 to 12 carbon atoms, aryl groups having 6 to 12 carbon atoms and silyl groups having the formula (I'), at least one of the groups R⁶ to R¹⁰ being invariably hydrogen, and a hydrotrisilane having the formula: 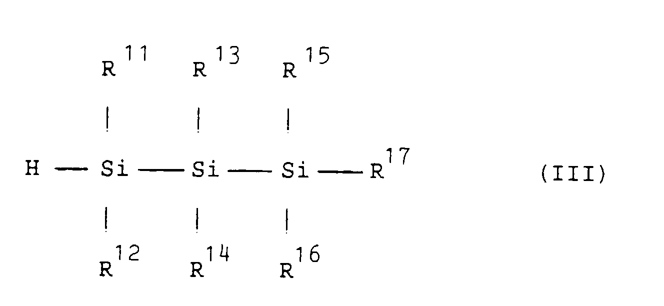 wherein R¹² to R¹⁷ are independently selected from the group consisting of a hydrogen atom and alkyl, cycloalkyl and halogenated alkyl groups having up to 12 carbon atoms, aralkyl groups and halogenated aralkyl groups having from 7 to 12 carbon atoms, aryl groups having 6 to 12 carbon atoms and silyl groups having the formula (I'), at least one of the groups R¹¹ to R¹⁷ being invariably hydrogen, in the presence of a catalyst comprising at least one of the metals and/or metal compounds of Groups 3B to 7B and 8 of the Periodic Table, and thermally decomposing said condensate at a temperature of 100 to 700 degrees Celsius.

It has now been found that the above objective of the invention can be achieved by subjecting a certain class of hydrosilane monomers to hydrogenative condensation in the presence of a catalyst comprising a specified metal or metal compound and a mixture thereof with a specified silyl compound or a specified metal hydride, and thermally decomposing the resultant condensate.

The source of stockfeed for the semiconductor materials contemplated under the invention is sought from hydrosilane monomers including a hydromonosilane, a hydrodisilane and a hydrotrisilane.

The hydromonosilane is represented by the formula 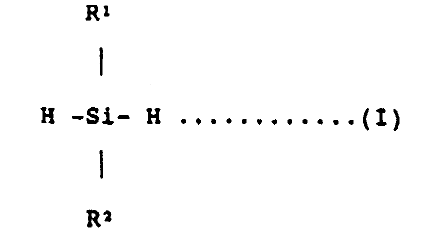 wherein R¹ and R² are identical or different and each include hydrogen, C₁-C₁₂ alkyl, cycloalkyl and halogenated alkyl groups, C₇-C₁₂ aralkyl and halogenated aralkyl groups, C₆-C₁₂ aryl groups and silyl groups of the formula

R³ R⁴ R⁵ Si- (I')

wherein R³, R⁴ and R⁵ are identical or different and each include C₁-C₈ alkyl groups and C₆-C₁₀ aryl groups.
The hydrodisilane is represented by the formula 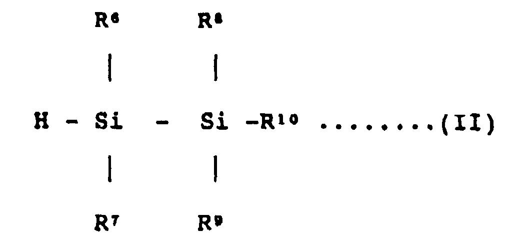 wherein R⁶-R¹⁰ are identical or different and each include hydrogen, C₁-C₁₂ alkyl, cycloalkyl and halogenated alkyl groups, C₇-C₁₂ aralkyl and halogenated aralkyl groups, C₆-C₁₂ aryl groups, and silyl groups of the formula (I'), either one of R⁶-R¹⁰ being invariably hydrogen.
The hydrotrisilane is represented by the formula 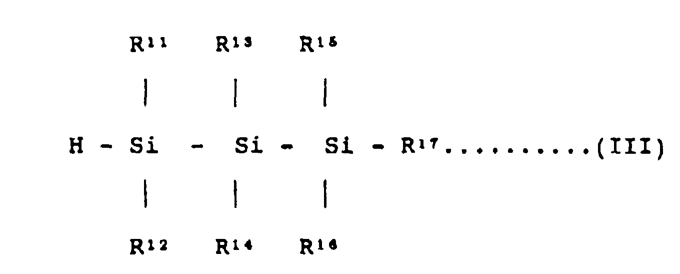 wherein R¹¹-R¹⁷ are identical or different and each include hydrogen, C₁-C₁₂ alkyl, cycloalkyl and halogenated alkyl groups, C₇-C₁₂ aralkyl and halogenated aralkyl, C₆-C₁₂ aryl groups, and silyl groups of the formula (I'), either one of R¹¹-R¹⁷ being invariably hydrogen.

The starting monomer (I) preferably includes silane, methylsilane, ethylsilane, n-propylsilane, (3,3,3-trifluoro propyl)silane, n-butylsilane, t-butylsilane, (1-methylpropyl)silane, (2-methylpropyl)silane, amylsilane, n-hexylsilane, cyclohexylsilane, n-heptylsilane, n-octylsilane, n-nonylsilane, n-decylsilane, n-dodecylsilane, phenylsilane, P-tolysilane, mesitylsilane, benzylsilane, phenethylsilane, (trimethylsilylmethyl)silane, dimethylsilane, diethylsilane, di-n-propylsilane, di-n-butylsilane, di-n-hexylsilane, di-n-octylsilane, diphenylsilane, dibenzylsilane, diphenethylsilane, methylphenylsilane, P-tolylmethylsilane, benzylmethylsilane, and methylphenethylsilane.

Other monomers eligible for the purpose of the invention includes bis(3,3,3-trifluoropropyl)silane, di-n-butylsilane, di-t-butylsilane, di(1-methylpropyl)silane, di(2-methylpropyl)silane, diamylsilane, dicyclohexylsilane, di-n-heptylsilane, di-n-nonylsilane, di-n-decylsilane, di-n-dodecylsilane, di-P-tolylsilane, dimethylsilane, bis(trimethylsilylmethyl)silane, ethylmethylsilane, methyl-n-propylsilane, methyl(3,3,3-trifluoropropyl)silane, methyl-i-propylsilane, n-butylmethylsilane, t-butylmethylsilne, methyl(1-methylpropyl)silane, methyl(2-methylpropyl)silane, amylmethylsilane, n-hexylmethylsilane, cyclohexylmethylsilane, n-heptylmethylsilane, methyl-n-octylsilane, methyl-n-nonylsilane, n-decylmethylsilane, n-dodecylmethylsilane, methylmesitylsilane, methyl(trimethylsilylmethyl)silane, (P-methylphenethyl)silane, ethylphenylsilane, and t-butylphenylsilane.

The starting monomer (II) preferably includes disilane, methyldisilane, ethyldisilane, n-propyldisilane, (3,3,3-trifluoropropyl)disilane, n-butyldisilane, t-butyldisilane, (1-methylpropyl)disilane, (2-methylpropyl)disilane, amyldisilane, n-hexyldisilane, cyclohexyldisilane, n-heptyldisilane, n-octyldisilane, n-nonyldisilane, n-decyldisilane, n-dodecyldisilane, phenyldisilane, p-tolyldisilane, mesityldisilane, benzyldisilane, phenethyldisilane, (trimethylsilylmethyl)disilane, 1,1-dimethyldisilane, 1,1-diethyldisilane, 1,1-di-n-propyldisilane, 1-1,di-n-butyldisilane, 1,1-di-n-amyldisilane, 1,1-di-n-hexyldisilane, 1,1-dicyclohexyldisilane, 1,1-diphenyldisilane, 1,1-dimesityldisilane, 1,2-dimethyldisilane, 1,2-diethyldisilane, 1,2-di-n-propyldisilane, 1,2-di-n-butyldisilane, 1,2-di-n-amyldisilane, 1,2-di-n-hexyldisilane, 1,2-dicyclohexyldisilane, 1,2-diphenyldisilane, and 1,2-dimesityldisilane.

Other eligible hydrodisilane monomers include 1-ethyl-1-methyldisilane, 1-methyl-1-n-propyldisilane, 1-methyl-1-i-propyldisilane, 1-n-butyl-1-methyl-disilane, 1-t-butyl-1-methyldisilane, 1-n-hexyl-1-methyldisilane, 1-cyclohexyl-1-methyldisilane, 1-n-heptyl-1-methyldisilane, 1-methyl-1-n-octyldisilane, 1-n-decyl-1-methyldisilane, 1-methyl-1-phenyldisilane, 1-1(p-methylphenethyl)-1-methyldisilane, 1-methyl-1-(β-phenethyl)disilane, 1-p-tolyl-1-methyldisilane, 1-phenyl-1-ethyldisilane, 1-t-butyl-1-phenyldisilane, 1-(phenyldimethylsilyl)-1-methyldisilane, 1-(trimethylsilyl)-1-methyldisilane, 1-ethyl-2-methyldisilane, 1-methyl-2-n-propyldisilane, 1-methyl-2-i-propyldisilane, 1-n-butyl-2-methyldisilane, 1-t-butyl-2-methyldisilane, 1-n-hexyl-2-methyldisilane, 1-cyclohexyl-2-methyldisilane, 1-n-heptyl-2-methyldisilane, 1-methyl-2-n-octyldisilane, 1-n-decyl-2-methyldisilane, 1-methyl-2-phenyldisilane, 1-(p-methylphenethyl)-2-methyldisilane, 1-methyl-2-(β-phenethyl)disilane, 1-p-tolyl-2-methyldisilane, 1-phenyl-2-ethyldisilane, 1-t-butyl-2-phenyldisilane, 1-(phenyldimethylsilyl)-2-methyldisilane, 1-(trimethylsilyl)-2-methyldisilane, trimethylsilyldisilane, triphenylsilyldisilane, (t-butyldimethylsilyl)disilane, 1,1,2-trimethyldisilane, 1,1,2-triethyldisilane, 1,1,2-tri-n-propyldisilane, 1,1,2-tri-n-butyldisilane, 1,1,2-tri-n-amyldisilane, 1,1,2-tri-n-hexyldisilane, 1,1,2-tricyclohexyldisilane, 1,1,2-triphenyldisilane, 1,1,2-trimesityldisilane, 1,1-diethyl-2-methyldisilane, 1,1-dimethyl-2-n-propyldisilane, 1,1-dimethyl-2-i-propyldisilane, 1,1-di-n-butyl-2-methyldisilane, 1,1-di-t-butyl-2-methyldisilane, 1,1-di-n-hexyl-2-methyldisilane, 1,1-dicyclohexyl-2-methyldisilane, 1,1-di-n-heptyl-2-methyldisilane, 1,1-dimethyl-2-n-octyldisilane, 1,1-di-n-decyl-2-methyldisilane, 1,1-dimethyl-2-phenyldisilane, 1,1-di-(p-methylphenethyl)-2-methyldisilane, 1,1-dimethyl-2-(β-phenethyl)disilane, 1,1-di-p-tolyl-2-methyldisilane, 1,1-diphenyl-2-ethyldisilane, 1,1-di-t-butyl-2-phenyldisilane, 1,1-di(phenyldimethylsilyl)-2-methyldisilane, 1,1-bis(trimethylsilyl)-2-methyldisilane, 1-ethyl-2,2-dimethyldisilane, 1-methyl-2,2-di-n-propyldisilane, 1-methyl-2,2-di-i-propyldisilane, 1-n-butyl-2,2-dimethyldisilane, 1-t-butyl-2,2-dimethyldisilane, 1-n-hexyl-2,2-dimethyldisilane, 1-cyclohexyl-2,2-dimethyldisilane, 1-n-heptyl-2,2-dimethyldisilane, 1-methyl-2,2-di-n-octyldisilane, 1-n-decyl-2,2-dimethyldisilane, 1-methyl-2,2-diphenyldisilane, 1-(p-methylphenethyl)-2,2-dimethyldisilane, 1-methyl-2,2-di(β-phenethyl)disilane, 1-p-tolyl-2,2-dimethyldisilane, 1-phenyl-2,2-diethyldisilane, 1-t-butyl-2,2-diphenyldisilane, 1-(phenyldimethylsilyl)-2,2-dimethyldisilane, 1-(trimethylsilyl)-2,2-dimethyldisilane, 1,1,1,2-tetramethyldisilane, 1,1,1,2-tetraethyldisilane, 1,1,1,2-tetra-n-propyldisilane, 1,1,1,2-tetra-n-butyldisilane, 1,1,1,2-tetra-n-amyldisilane, 1,1,1,2-tetra-n-hexyldisilane, 1,1,1,2-tetracyclohexyldisilane, 1,1,1,2-tetraphenyldisilane, 1,1,1,2-tetramethyldisilane, 1,1,2,2-tetramethyldisilane, 1,1,2,2-tetraethyldisilane, 1,1,2,2-tetra-n-propyldisilane, 1,1,2,2-tetra-n-butyldisilane, 1,1,2,2-tetra-n-amyldisilane, 1,1,2,2-tetra-n-hexyldisilane, 1,1,2,2-tetracyclohexyldisilane, 1,1,2,2-tetraphenyldisilane, 1,1,2,2-tetramesityldisilane, 1,1,1-triethyl-2-methyldisilane, 1,1,1-trimethyl-2-n-propyldisilane, 1,1,1-trimethyl-2-i-propyldisilane, 1,1,1-tri-n-butyl-2-methyldisilane, 1,1,1-tri-t-butyl-2-methyldisilane, 1,1,1-tri-n-hexyl-2-methyldisilane, 1,1,1-tricyclohexyl-2-methyldisilane, 1,1,1-n-heptyl-2-methyldisilane, 1,1,1-trimethyl-2-n-octyldisilane, 1,1,1-tri-n-decyl-2-methyldisilane, 1,1,1-trimethyl-2-phenyldisilane, 1,1,1-tri-(p-methylphenethyl)-2-methyldisilane, 1,1,1-trimethyl-2-(β-phenethyl)disilane, 1,1,1-tri-p-tolyl-2-methyldisilane, 1,1,1-triphenyl-2-ethyldisilane, 1,1,1-tri-t-butyl-phenyldisilane, 1,1,1-tri(phenyldimethyl)-2-methyldisilane, 1,1,1-tri(trimethylsilyl)-2-methyldisilane, 1-ethyl-2,2,2-trimethyldisilane, 1-methyl-2,2,2-tri-n-propyldisilane, 1-methyl-2,2,2-tri-i-propyldisilane, 1-n-butyl-2,2,2-trimethyldisilane, 1-t-butyl-2,2,2-trimethyldisilane, 1-n-hexyl-2,2,2-trimethyldisilane, 1-cyclohexyl-2,2,2-trimethyldisilane, 1-n-heptyl-2,2,2-trimethyldisilane, 1-methyl-2,2,2-tri-n-octyldisilane, 1-n-decyl-2,2,2-trimethyldisilane, 1-methyl-2,2,2-triphenyldisilane, 1-(p-methylphenethyl)-2,2,2-trimethyldisilane, 1-methyl-2,2,2-tri(β-phenethyl)disilane, 1-p-tolyl-2,2,2-trimethyldisilane, 1-phenyl-2,2,2-triethyldisilane, 1-t-butyl-2,2,2-triphenyldisilane, 1-(phenyldimethylsilyl)-2,2,2-trimethyldisilane, 1-(trimethylsilyl)-2,2,2-trimethyldisilane, 1,1-diethyl-2,2-dimethyldisilane, 1,1-dimethyl-2,2-di-n-propyldisilane, 1,1-dimethyl-2,2-di-i-propyldisilane, 1,1-di-n-butyl-2,2-dimethyldisilane, 1,1-di-t-butyl-2,2-dimethyldislane, 1,1-di-n-hexyl-2, 2-dimethyldisilane, 1,1-dicyclohexyl-2,2-dimethyldisilane, 1,1-di-n-heptyl-2,2-dimethyldisilane, 1,1-dimethyl-2,2-di-n-octyldisilane, 1,1-di-n-decyl-2,2-dimethyldisilane, 1,1-dimethyl-2,2-diphenyldisilane, 1,1-di(p-methylphenethyl)-2,2-dimethyldisilane, 1,1-dimethyl-2,2-di(β-phenethyl)disilane, 1,1-di-p-tolyl-2,2-dimethyldisilane, 1,1-diphenyl-2,2-diethyldisilane, 1,1-di-t-butyl-2,2-diphenyldisilane, 1,1-di(phenyldimethylsilyl)-2,2-dimethyldisilane, 1,1-bis(trimethylsilyl)-2,2-dimethyldisilane, 1,2-diethyl-1,2-dimethyldisilane, 1,2-dimethyl-1,2-di-n-propyldisilane, 1,2-dimethyl-1,2-di-i-propyldisilane, 1,2-di-n-butyl-1,2-dimethyldisilane, 1,2-di-t-butyl-1,2-dimethyldisilane, 1,2-di-n-hexyl-1,2-dimethyldisilane, 1,2-dicyclohexyl-1,2-dimethyldisilane, 1,2-di-n-heptyl-1,2-dimethyldisilane, 1,2-dimethyl-1,2-di-n-octyldisilane, 1,2-di-n-decyl-1,2-dimethyldisilane, 1,2-dimethyl-1,2-diphenyldisilane, 1,2-di-(p-methylphenethyl)-1,2-dimethyldisilane, 1,2-dimethyl-1,2-di(β-phenethyl)disilane, 1,2-di-p-tolyl-1,2-dimethyldisilane, 1,2-diphenyl-1,2-diethyldisilane, 1,2-di-t-butyl-1,2-diphenyldisilane, and 1,2-di(phenyldimethylsilyl)-1,2-dimethyldisilane.

The starting monomer (III) preferably includes trisilane, 1-methyltrisilane, 1-ethyltrisilane, 1-n-propyltrisilane, 1-(3,3,3-trifluoropropyl)trisilane, 1-n-butyltrisilane, 1-t-butyltrisilane, 1-(1-methylpropyl)trisilane, 1-(2-methylpropyl)trisilane, 1-amyltrisilane, 1-n-hexyltrisilane, 1-cyclohexyltrisilane, 1-n-heptyltrisilane, 1-n-octyltrisilane, 1-n-nonyltrisilane, 1-n-decyltrisilane, 1-n-dodecyltrisilane, 1-phenyltrisilane, 1-p-tolyltrisilane, 1-mesityltrisilane, 1-benzyltrisilane, 1-phenethyltrisilane, 1-(trimethylsilylmethyl)trisilane, 2-methyltrisilane, 2-ethyltrisilane, 2-n-propyltrisilane, 2-(3,3,3-trifluoropropyl)trisilane, 2-n-butyltrisilane, 2-t-butyltrisilane, 2-(1-methylpropyl)trisilane, 2-(2-methylpropyl)trisilane, 2-amyltrisilane, 2-n-hexyltrisilane, 2-cyclohexyltrisilane, 2-n-heptyltrisilane, 2-n-octyltrisilane, 2-n-nonyltrisilane, 2-n-decyltrisilane, 2-n-dodecyltrisilane, 2-phenyltrisilane, 2-p-tolyltrisilane, 2-mesityltrisilane, 2-benzyltrisilane, 2-phenethyltrisilane, 2-(trimethylsilylmethyl)trisilane, 1,1-dimethyltrisilane, 1,1-diethyltrisilane, 1,1-di-n-propyltrisilane, bis(3,3,3-trifluoropropyl)trisilane, 1,1-di-n-butyltrisilane, 1,1-di-t-butyltrisilane, di(1-methylpropyl)trisilane, di(2-methylpropyl)trisilane, 1,1-diamyltrisilane, 1,1-di-n-hexyltrisilane, 1,1-dicyclohexyltrisilane, 1,1-di-n-heptyltrisilane, 1,1-di-n-octyltrisilane, 1,1-di-n-nonyltrisilane, 1,1-di-n-decyltrisilane, 1,1-di-n-dodecyltrisilane, 1,1-diphenyltrisilane, 1,1-di-p-tolyltrisilane, 1,1-dimethyltrisilane, 1,1-dibenzyltrisilane, 1,1-diphenethyltrisilane, 1,1-bis(trimethylsilylmethyl)trisilane, 1,2-dimethyltrisilane, 1,2-diethyltrisilane, 1,2-di-n-propyltrisilane, bis(3,3,3-trifluoropropyl)trisilane, 1,2-di-n-butyltrisilane, 1,2-di-t-butyltrisilane, di(1-methylpropyl)trisilane, di(2-methylpropyl)trisilane, 1,2-diamyltrisilane, 1,2-di-n-hexyltrisilane, 1,2-dicyclohexyltrisilane, 1,2-di-n-heptyltrisilane, 1,2-di-n-octyltrisilane, 1,2-di-n-nonyltrisilane, 1,2-di-n-decyltrisilane, 1,2-di-n-dodecyltrisilane, 1,2-diphenyltrisilane, 1,2-di-p-tolyltrisilane, 1,2-dimesityltrisilane, 1,2-dibenzyltrisilane, 1,2-diphenethyltrisilane, 1,2-bis(trimethylsilylmethyl)trisilane, 1,3-dimethyltrisilane, 1,3-diethyltrisilane, 1,3-di-n-propyltrisilane, bis(3,3,3-trifluoropropyl)trisilane, 1,3-di-n-butyltrisilane, 1,3-di-t-butyltrisilane, di(1-methylpropyl)trisilane, di(2-methylpropyl)trisilane, 1,3-diamyltrisilane, 1,3-di-n-hexyltrisilane, 1,3-dicyclohexyltrisilane, 1,3-di-n-heptyltrisilane, 1,3-di-n-octyltrisilane, 1,3-di-n-nonyltrisilane, 1,3-di-n-decyltrisilane, 1,3-di-n-dodecyltrisilane, 1,3-diphenyltrisilane, 1,3-di-p-tolyltrisilane, 1,3-dimethyltrisilane, 1,3-dibenzyltrisilane, 1,3-diphenethyltrisilane, 1,3-bis(trimethylsilylmethyl)trisilane, 1,1,1-trimethyltrisilane, 1,1,1-triethyltrisilane, 1,1,1-tri-n-propyltrisilane, 1,1,1-tris(3,3,3-trifiuoropropyl)trisilane, 1,1,1-tri-n-butyltrisilane, 1,1,1-tri-t-butyltrisilane, 1,1,1-tri(1-methylpropyl)trisilane, 1,1,1-tri(2-methylpropyl)trisilane, 1,1,1-triamyltrisilane, 1,1,1-tri-n-hexyltrisilane, 1,1,1-tricyclohexyltrisilane, 1,1,1-tri-n-heptyltrisilane, 1,1,1-tri-n-octyltrisilane, 1,1,1-tri-n-nonyltrisilane, 1,1,1-tri-n-decyltrisilane, 1,1,1-tri-n-dodecyltrisilane, 1,1,1-triphenyltrisilane, 1,1,1-tri-p-tolyltrisilane, 1,1,1-trimesityltrisilane, 1,1,1-tribenzyltrisilane, 1,1,1-triphenethyltrisilane, 1,1, 1-tris(trimethylsilylmethyl)trisilane, 1-ethyl-1,1-dimethyltrisilane, 1-methyl-1,1-di-n-propyltrisilane, 1-methyl-1,1-bis(3,3,3-trifluoropropyl)trisilane, 1-methyl-1,1-di-i-propyltrisilane, 1-n-butyl-1,1-dimethyltrisilane, 1-t-butyl-1,1-dimethyltrisilane, 1-methyl-1,1-di(1-methylpropyl)trisilane, 1-methyl-1,1-di(2-methylpropyl)trisilane, 1-amyl-1,1-dimethyltrisilane, 1-n-hexyl-1,1-dimethyltrisilane, 1-cyclohexyl-1,1-dimethyltrisilane, 1-n-heptyl-1,1-dimethyltrisilane, 1-methyl-1,1-di-n-octyltrisilane, 1-methyl-1,1-di-n-nonyltrisilane, 1-n-decyl-1,1-dimethyltrisilane, 1-n-dedecyl-1,1-dimethyltrisilane, 1-methyl-1,1-diphenyltrisilane, 1-p-tolyl-1,1-dimethyltrisilane, 1-methyl-1,1-dimethyltrisilane, 1-benzyl-1,1-dimethyltrisilane, 1-methyl-1,1-diphenethyltrisilane, 1-methyl-1,1-bis(trimethylsilylmethyl)trisilane, 1-(p-methylphenethyl)-1,1-dimethyltrisilane and 1-ethyl-1,1-diphenyltrisilane.

Other eligible hydrotrisilane monomers include 1-ethyl-1-methyltrisilane, 1-methyl-1-n-propyltrisilane, 1-methyl-1-(3,3,3-trifluoropropyl)trisilane, 1-methyl-1-i-propyltrisilane, 1-n-butyl-1-methyltrisilane, 1-t-butyl-1-methyltrisilane, 1-methyl-1-(1-methylpropyl)trisilane, 1-methyl-1-(2-methylpropyl)trisilane, 1-amyl-1-methyltrisilane, 1-n-hexyl-1-methyltrisilane, 1-cyclohexyl-1-methyltrisilane, 1-n-heptyl-1-methyltrisilane, 1-methyl-1-n-octyltrisilane, 1-methyl-1-n-nonyltrisilane, 1-n-decyl-1-methyltrisilane, 1-n-dodecyl-1-methyltrisilane, 1-methyl-1-phenyltrisilane, 1-p-tolyl-1-methyltrisilane, 1-mesityl-1-methyltrisilane, 1-benzyl-1-methyltrisilane, 1-methyl-1-phenethyltrisilane, 1-methyl-1-(trimethylsilylmethyl)trisilane, 1-(p-methylphenethyl)-1-methyltrisilane, 1-ethyl-1-phenyltrisilane, 1-t-butyl-1-phenyltrisilane, 1-ethyl-2-methyltrisilane, 1-methyl-2-n-propyltrisilane, 1-methyl-2-(3,3,3-trifluoropropyl)trisilane, 1-methyl-2-i-propyltrisilane, 1-n-butyl-2-methyltrisilane, 1-t-butyl-2-methyltrisilane, 1-methyl-2-(1-methylpropyl)trisilane, 1-methyl-2-(2-methylpropyl)trisilane, 1-amyl-2-methyltrisilane, 1-n-hexyl-2-methyltrisilane, 1-cyclohexyl-2-methyltrisilane, 1-n-heptyl-2-methyltrisilane, 1-methyl-2-n-octyltrisilane, 1-methyl-2-n-nonyltrisilane, 1-n-decyl-2-methyltrisilane, 1-n-dodecyl-2-methyltrisilane, 1-methyl-2-phenyltrisilane, 1-p-tolyl-2-methyltrisilane, 1-methyl-2-mesityltrisilane, 1-benzyl-2-methyltrisilane, 1-methyl-2-phenethyltrisilane, 1-methyl-2-(trimethylsilylmethyl)trisilane, 1-(p-methylphenethyl)-2-methyltrisilane, 1-ethyl-2-phenyltrisilane, 1-t-butyl-2-phenyltrisilane, 1-ethyl-3-methyltrisilane, 1-methyl-3-n-propyltrisilane, 1-methyl-3-(3,3,3-trifluoropropyl)trisilane, 1-methyl-3-i-propyltrisilane, 1-n-butyl-3-methyltrisilane, 1-t-butyl-3-methyltrisilane, 1-methyl-3-(1-methylpropyl)trisilane, 1-methyl-3-(2-methylpropyl)trisilane, 1-amyl-3-methyltrisilane, 1-n-hexyl-3-methyltrisilane, 1-cyclohexyl-3-methyltrisilane, 1-n-heptyl-3-methyltrisilane, 1-methyl-3-n-octyltrisilane, 1-methyl-3-n-nonyltrisilane, 1-n-decyl-3-methyltrisilane, 1-n-dodecyl-3-methyltrisilane, 1-methyl-3-phenyltrisilane, 1-p-tolyl-3-methyltrisilane, 1-methyl-3-mesityltrisilane, 1-benzyl-3-methyltrisilane, 1-methyl-3-phenethyltrisilane, 1-methyl-3-(trimethylsilylmethyl)trisilane, 1-(p-methylphenethyl)-3-methyltrisilane, 1-ethyl-3-phenyltrisilane, 1-t-butyl-3-phenyltrisilane, 1,1,2-trimethyltrisilane, 1,1,2-triethyltrisilane, 1,1,2-tri-n-propyltrisilane, 1,1,2-tris(3,3,3-trifluoropropyl)trisilane, 1,1,2-tri-n-butyltrisilane, 1,1,2-tri-t-butyltrisilane, 1,1,2-tri(1-methylpropyl)trisilane, 1,1,2-tri(2-methylpropyl)trisilane, 1,1,2-triamyltrisilane, 1,1,2-tri-n-hexyltrisilane, 1,1,2-tricyclohexyltrisilane, 1,1,2-tri-n-heptyltrisilane, 1,1,2-tri-n-octyltrisilane, 1,1,2-tri-n-nonyltrisilane, 1,1,2-tri-n-decyltrisilane, 1,1,2-tri-n-dodecyltrisilane, 1,1,2-triphenyltrisilane, 1,1,2-tri-p-tolyltrisilane, 1,1,2-trimethyltrisilane, 1,1,2-tribenzyltrisilane, 1,1,2-triphenethyltrisilane, 1,1,2-tris(trimethylsilylmethyl)trisilane, 1,1,3-trimethyltrisilane, 1,1,3-triethyltrisilane, 1,1,3-tri-n-propyltrisilane, 1,1,3-tris(3,3,3-trifluoropropyl)trisilane, 1,1,3-tri-n-butyltrisilane, 1,1,3-tri-t-butyltrisilane, 1,1,3-tri(1-methylpropyl)trisilane, 1,1,3-tri(2-methylpropyl)trisilane, 1,1,3-triamyltrisilane, 1,1,3-tri-n-hexyltrisilane, 1,1,3-tricyclohexyltrisilane, 1,1,3-tri-n-heptyltrisilane, 1,1,3-tri-n-octyltrisilane, 1,1,3-tri-n-nonyltrisilane, 1,1,3-tri-n-decyltrisilane, 1,1,3-tri-n-dodecyltrisilane, 1,1,3-triphenyltrisilane, 1,1,3-tri-p-tolyltrisilane, 1,1,3-trimesityltrisilane, 1,1,3-tribenzyltrisilane, 1,1,3-triphenethyltrisilane, 1,1,3-tris(trimethylsilylmethyl)trisilane, 1,2,3-trimethyltrisilane, 1,2,3-triethyltrisilane, 1,2,3-tri-n-propyltrisilane, 1,2,3-tris(3,3,3-trifluoropropyl)trisilane, 1,2,3-tri-n-butyltrisilane, 1,2,3-tri-t-butyltrisilane, 1,2,3-tri(1-methylpropyl)trisilane, 1,2,3-tri(2-methylpropyl)trisilane, 1,2,3-triamyltrisilane, 1,2,3-tri-n-hexyltrisilane, 1,2,3-tricyclohexyltrisilane, 1,2,3-tri-n-heptyltrisilane, 1,2,3-tri-n-octyltrisilane, 1,2,3-tri-n-nonyltrisilane, 1,2,3-tri-n-decyltrisilane, 1,2,3-tri-n-dodecyltrisilane, 1,2,3-triphenyltrisilane, 1,2,3-tri-p-tolyltrisilane, 1,2,3-trimesithyltrisilane, 1,2,3-tribenzyltrisilane, 1,2,3-triphenethyltrisilane, 1,2,3-tris(trimethylsilylmethyl)trisilane, 1,1-diethyl-2-methyltrisilane, 1,1-dimethyl-2-n-propyltrisilane, 1,1-dimethyl-2-i-propyltrisilane, 1,1-di-n-butyl-2-methyltrisilane, 1,1-di-t-butyl-2-methyltrisilane, 1,1-di-n-hexyl-2-methyltrisilane, 1,1-dicyclohexyl-2-methyltrisilane, 1,1-di-n-heptyl-2-methyltrisilane, 1,1-dimethyl-2-n-octyltrisilane, 1,1-di-n-decyl-2-methyltrisilane, 1,1-dimethyl-2-phenyltrisilane, 1,1-di(p-methylphenethyl)-2-methyltrisilane, 1,1-dimethyl-2-(β-phenethyl)trisilane, 1,1-di-p-tolyl-2-methyltrisilane, 1,1-diphenyl-2-ethyltrisilane, 1,1-di-t-butyl-2-phenyltrisilane, 1,1-di(phenyldimethylsilyl)-2-methyltrisilane, 1,1-bis(trimethylsilyl)-2-methyltrisilane, 1,1-diethyl-3-methyltrisilane, 1,1-dimethyl-3-n-propyltrisilane, 1,1-dimethyl-3-i-propyltrisilane, 1,1-di-n-butyl-3-methyltrisilane, 1,1-di-t-butyl-3-methyltrisilane, 1,1-di-n-hexyl-3-methyltrisilane, 1,1-dicyclohexyl-3-methyltrisilane, 1,1-di-n-heptyl-3-methyltrisilane, 1,1-dimethyl-3-n-octyltrisilane, 1,1-di-n-decyl-3-methyltrisilane, 1,1-dimethyl-3-phenyltrisilane, 1,1-di-(p-methylphenethyl)-3-methyltrisilane, 1,1-dimethyl-3-(β-phenethyl)trisilane, 1,1-di-p-tolyl-3-methyltrisilane, 1,1-diphenyl-3-ethyltrisilane, 1,1-di-t-butyl-3-phenyltrisilane, 1,1-di(phenyldimethylsilyl)-3-methyltrisilane, 1,1-bis(trimethylsilyl)-3-methyltrisilane, 1,2-diethyl-3-methyltrisilane, 1,2-dimethyl-3-n-propyltrisilane, 1,2-dimethyl-3-i-propyltrisilane, 1,2-di-n-butyl-3-methyltrisilane, 1,2-di-t-butyl-3-methyltrisilane, 1,2-di-n-hexyl-3-methyltrisilane, 1,2-dicyclohexyl-3-methyltrisilane, 1,2-di-n-heptyl-3-methyltrisilane, 1,2-dimethyl-3-n-octyltrisilane, 1,2-di-n-decyl-3-methyltrisilane, 1,2-dimethyl-3-phenyltrisilane, 1,2-di(p-methylphenethyl)-3-methyltrisilane, 1,2-dimethyl-3-(β-phenethyl)trisilane, 1,2-di-p-tolyl-3-methyltrisilane, 1,2-diphenyl-3-ethyltrisilane, 1,2-di-t-butyl-3-phenyltrisilane, 1,2-di(phenyldimethylsilyl)-3-methyltrisilane and 1,2-bis(trimethylsilyl)-3-methyltrisilane.

One example of the catalyst for use in the invention comprises at least one of the metals and/or metal compounds of Groups 3B-7B and 8 of the Periodic Table, which include lanthanides such as actinide of the Group 3B, titanium, zirconium, hafnium of the Group 4B, vanadium, niobium, tantalum of the Group 5B, chromium, molybdenum, tungsten of the Group 6B, manganese, technetium, rhenium of the Group 7B and iron, ruthenium, osmium, cobalt, rhodium, iridium, nickel, palladium, platinum of the Group 8 and their respective compounds, of which lanthanides, titanium, zirconium, hafnium, tuthenium, cobalt, rhodium, iridium, nickel, palladium and platinum are preferred.

The lanthanide compound exemplarily includes aniline acetate lanthanide, lanthanide(acetylacetonato), lanthanide halogenide, tetra(t-buthyl)lithiumlanthanide, tetraphenyllanthanidelithium, methyllanthanide iodide, phenyllanthanide iodide, bis(η-cyclopentadienyl)lanthanide, chlorobis(η-cyclopentadienyl)lanthanide, dichlorobis(η-cyclopentadienyl)lanthanide, tris(η-cyclopentadienyl)lanthanide, bis(trimethylsilyl)methylbis(η -pentamethylcyclopenthadienyl)- lanthanide, hydridebis(η-pentamethylcyclopentadienyl)lanthanide, methylbis(η-cyclopentadienyl)lanthanide and bis(η-cyclopentadienyl)lanthanidedi(µ-methyl)-dimethylalminum.

The titanium compound exemplarily includes (η-cycloheptatrienyl)(η-cyclopentadienyl)titanium, titanium hydride, dicarbonylbis(η-cyclopentadienyl)titanium, bis(η-pentamethylcyclopentadienyl)titanium, titanium trichloride, chlorobis(η-cyclopentadienyl)titanium, dichloro(η-cyclopentadienyl)titanium, titanium tetrachloride, titanium tetrabromide, titanium tetraiodide, trichloromethyltitanium, methyltriisopropoxytitanium, titanium tetraethoxide, titanium tetrapropoxide, titanium tetraisopropoxide, titanium tetrabutoxide, dihydridebis(η-pentamethylcyclopentadiethyl)titanium, trichloro(η-cyclopentadienyl)titanium, dichlorobis(η-cyclopentadienyl)titanium, dichlorobis(η-methylcyclopentadienyl)titanium, dichlorobis(η-dimethylcyclopentadienyl)titanium, dichlorobis(η-trimethylcyclopentadienyl)titanium, dichlorobis(η-pentamethylcyclopentadienyl)titanium, dichlorobis(η-trifluoromethylcyclopentadienyl)titanium, dichlorobis(η-trimethylsilylcyclopentadienyl)titanium, dichloro(η-pentamethylcyclopentadienyl)(η-cyclopentadienyl)titanium, dichloro(η-trifluoromethylcyclopentadienyl)(η-cyclopentadienyl)titanium, dichloromethylenebis(η-cyclopentadienyl)titanium, dichloroethylenebis(η-cyclopentadienyl)titanium, dichloropropylenebis(η-cyclopentadienyl)titanium, dichlorodimethylsilylenebis(η-cyclopentadienyl)titanium, dichlorobis(η-indenyl)titanium, dichlorobis(η-methylindenyl)titanium, dichlorobis(η-dimethylindenyl)titanium, dichlorobis(η-trimethylsilylindeyl)titanium, dichloromethylenebis(η-indenyl)titanium, dichloroethylenebis(η-indenyl)titanium, dichloropropylenebis(η-indenyl)titanium, dimethylbis(η-cyclopentadienyl)titanium, dimethylbis(η-methylcyclopentadienyl)titanium, dimethylbis(η-pentamethylcyclopentadienyl)titanium, dimethylbis(η-trimethylsilylcyclopentadienyl)titanium, dimethylbis(η-indenyl)titanium, diphenylbis(η-cyclopentadienyl)titanium, diphenylbis(η-methylcyclopentadienyl)titanium, dibenzylbis(η-cyclopentadienyl)titanium, bis(trimethylsilylmethyl)bis(η-cyclopentadienyl)titanium, dimethoxybis(η-cyclopentadienyl)titanium, diethoxybis(η-cyclopentadienyl)titanium, dibutoxybis(η-cyclopentadienyl)titanium and diphenoxibis(η-cyclopentadienyl)titanium.

The zirconium compound exemplarily includes bis(η-cyclooctatetraene)zirconium, zirconium hydroxide, bis(η-cyclopentadienyl)(η-1,3-butadiene)zirconium, dicarbonylbis(η-cyclopentadienyl)zirconium, chlorobis(η-cyclopentadienyl)zirconium, benzylbis (η-cyclopentadienyl)zirconium, trimethylsilylmethylbis(η-cyclopentadienyl)zirconium, zirconium tetrachloride, zirconium acetylacetonato, zirconiumtetraethoxide, zirconiumtetrabutoxide, tetraallyzirconium, trichloro(η-pentamethylcyclopentadienyl)zirconium, tribromo(η-cyclopentadienyl)zirconium, bis(η-cyclopentadienyl)dihydride zirconium, chlorobis(η-cyclopentadienyl)hydride zirconium, bis(tetrahydroborate)bis(η-cyclopentadienyl)zirconium, dichlorobis(η-cyclopentadienyl)zirconium, dichlorobis(η-methylcyclopentadienyl)zirconium, dichlorobis(η-dimethylcyclopentadienyl)zirconium, dichlorobis(η-trimethylcyclopentadienyl)zirconium, dichlorobis(η-pentamethylcyclopentadienyl)zirconium, dichlorobis(η-trifluoromethylcyclopentadienyl)zirconium, dichlorobis(η-trimethylsilylcyclopentadienyl)zirconium, dichloro(η-pentamethylcyclopentadienyl) (η-cyclopentadienyl)-zirconium, dichloro(η-trifluromethylcyclopentadienyl)(η-cyclopentadienyl)zirconium, dichloromethylenebis(η-cyclopentadienyl)zirconium, dichloroethylenebis(η-cyclopentadienyl)zirconium, dichloropropylenebis(η-cyclopentadienyl)zirconium, dichlorodimethylsilylenebis(η-cyclopentadienyl)zirconium, dichlorobis(η-indenyl)zirconium, dichlorobis(η-methylindenyl)zirconium, dichlorobis(η-dimethylindenyl)zirconium, dichlorobis(η-trimethylsilylindenyl)zirconium, dichloromethylenebis(η-indenyl)zirconium, dichloroethylenebis(η-indenyl)zirconium, dichloropropylenebis(η-indenyl)zirconium, dimethylbis(η-cyclopentadienyl)zirconium, dimethylbis(η-pentamethylcyclopentadienyl)zirconium, dimethylbis(η-indenyl)zirconium, diphenylbis(η-cyclopentadienyl)zirconium, diphenylbis(η-methylcyclopentadienyl)zirconium, dibenzylbis(η-cyclopentadienyl)zirconium, bis(trimethylsilylmethyl)bis(η-cyclopentadienyl)zirconium, dimethoxybis(η-cyclopentadienyl)zirconium, diethoxybis(η-cyclopentadienyl)zirconium, dibutoxybis(η-cyclopentadienyl)zirconium and diphenoxybis(η-cyclopentadienyl)zirconium.

The hafnium compound exemplarily includes bis(ηbutadiene)[1,2-bis(dimethylphosphino)ethane]hafnium, dicarbonylbis(η-cyclopentadienyl)hafnium, trimethylsilylmethylbis(η-isopropylcyclopentadienyl)-hafnium, tetrabenzylhafnium, trichloro(η-cyclopentadienyl)hafnium, chlorobis(η-cyclopentadienyl)hydride )hydride hafnium, dihydridobis(η-cyclopentadienyl)hafnium, bis(tetrahydroborate)bis(η-methylcyclopentadienyl)-hafnium, dichlorobis(η-cyclopentadienyl)hafnium, dichlorobis(η-methylcyclopentadienyl)hafnium, dichlorobis(η-dimethylcyclopentadienyl)hafnium, dichlorobis(ηtrimethylcyclopentadienyl)hafnium, dichloro(η-pentamethylcyclopentadienyl)-(η-cyclopentadienyl)hafnium, dichloro(η-trifluoromethylcyclopentadienyl)-(η-cyclopentadienyl)hafnium, dichlomethylenebis(η-cyclopentadienyl)hafnium, dichloroethylenebis(η-cyclopentadienyl)hafnium, dichlopropylenebis(η-cyclopentadienyl)hafnium, dichlorodimethylsilylenebis(η-cyclopentadienyl)hafnium, dichlorobis(η-indenyl)hafnium, dichlorobis(η-methylindenyl)hafnium, dichlorobis(η-dimethylindenyl)hafnium, dichlorobis(η-trimethylindenyl)hafnium, dichloromethylenebis(η-indenyl)hafnium, dichloroethylenebis(η-indenyl)hafnium, dichloropropylenebis(η-indenyl)hafnium, dimethylbis(η-cyclopentadienyl)hafnium, dimethylbis(η-pentamethylcyclopentadienyl)hafnium, dimethylbis(η-indenyl)hafnium, diphenylbis(η-cyclopentadienyl)hafnium, dipehnylbis(η-methylcyclopentadienyl)hafnium, dibenzylbis(η-cyclopentadienyl)hafnium, bis(trimethylsilylmethyl)bis(η-cyclopentadienyl)hafnium, dimethoxybis(η-cyclopentadienyl)hafnium, diethoxybis(η-cyclopentadienyl)hafnium, dibutoxybis(η-cyclopentadienyl)hafnium, and diphenoxybis(η-cyclopentadienyl)hafnium.

The cobalt compound exemplarily includes hexacarbonylbis(tributylphosphine)dicobalt, hexacarbonyl -µ-(diphenylacetylene)dicobalt, tetracarbonylbis(µ-butadiene)dicobalt, dodecarbonyltetracobalt, hydridotetracarbonylcobalt, tetracarbonyl(trimethylsilyl)cobalt, (η -allyl)tricarbonylcobalt, hydrido(dinitrogen)tris(triphenylphosphine)cobalt, tetrakis(trimethylphosphine)methylcobalt, dicarbonyl(η-cyclopnetadienyl)cobalt, bis(µ-carbonyl)(η-cyclopentadienyl)cobalt], tris[(µ-carbonyl)(η-cyclopentadienyl)cobalt], dicarbonyl(η-pentamethylcyclopentadienyl)cobalt, bis(trimethylphosphido)(η-cyclopentadienyl)cobalt, chlorotris(triphenylphosphine)cobalt, (η-cyclopentadienyl)bis(triphenylphosphine)cobalt, (η-cyclopentadienyl)bis(η-ethylene )cobalt, (η-cyclopentadienyl)(η-1,5-cyclooctadiene)cobalt, (η-cyclopentadienyl)(η-cyclohexadiene)cobalt, cobalt acetate, cobalt(acetylacetonato), cobalt chloride, cobalt bromide, cobalt iodide, cobalt thiocyanate, bis(η-cyclopentadienyl)cobalt, carbonyl(η-cyclopentadienyl)diiodocobalt, (η-cyclopentadienyl)(triphenylphosphine)diiodocobalt, bis(η-cyclopentadienyl)cobalt tribromide, (η-cyclopnetadienyl)(η-cyclohexadienyl)cobalt iodide and (η-benzene)(η-cyclopentadienyl)cobalt tetrafluoroborate.

The nickel compound exemplarily includes tetracarbonylnickel, dicarbonylbis(triphenylphosphine)nickel, bis(1,5-cyclooctadiene)nickel, (η-ethylene)bis(triphenylphosphine)nickel, tetrakis(triphenylphosphine)nickel, tetrakis(t-butylisocyanide)nickel, µ-(dinitrogen)bis[bis(tricyclohexylphosphine)nickel], nickelacetate, nickel(acetylacetonato), nickel chloride, nickel bromide, dichloro[1,2-bis(diphenylphosphino)ethane]nickel, trans-bis(1,3-butadiynyl)bis(tributylphosphine)nickel, dimethylbis(trimethylphosphine)nickel, diethyl(2,2'-bipyridyl)nickel, trans-bromo(phenyl)bis(triethylphosphine)nickel, tetramethylenebis(triphenylphosphine)nickel, trans-chloro(hydride)bis(tricyclohexylphosphine)nickel, bis(η-cyclopentadienyl)nickel, chloro(η-cyclopentadienyl)(triphenylphosphine)nickel, methyl(η-cyclopentadienyl)(triphenylphosphine)nickel, (η-allyl)(η-cyclopentadienyl)nickel, (η-1,5-cyclooctadiene)(η-cyclopentadienyl) nickeltetrafluoro borate, bis (η-allyl)nickel, (η-allyl)broma(triphenylphosphine)nickel, and bis(η-cyclopentadienyl)di(µ-carbonyl)dinickel.

The ruthenium compound exemplarily includes ruthenium carbon, ruthenium allumina, dodecacarbonyltri ruthenium, tetra-µ-hydridedodecacarbonyltetraruthenium, tetracarbonyl(trimethylphosphido)ruthenium, pentakis(trimethylphosphido)ruthenium, tricarbonyl(cyclooctatetraene)ruthenium, tricarbonyl(1,5-cyclooctadiene)ruthenium, tetracarbonylbis(η-cyclopentadienyl)diruthenium, tetracarbonylbis(η-pentamethylcyclopnetadienyl)-diruthenium, dicarbonyltris(triphenylphosphine)ruthenium, diacetatodicarbonylbis(triphenylphoophine)ruthenium, di-µ-chlorobis(chlorotricarbonylruthenium), dichlorotris(triphenylphosphine)ruthenium, carbonylchlorohydridotris(triphenylphosphine)rutherium, dihydridotetrakis(triphenylphosphine)ruthenium, trans-dichlorotetrakis(t- butyl isocyanide)ruthenium, bis(η-cyclopentadienyl)ruthenium, chloro(η-cyclopentadienyl)bis(triphenylphosphine)-ruthenium, hydrido(cyclopentadienyl)bis(trimethylphosphine)-rutheniumhexafluorophosphate, chlorodicarbonyl(η-cyclopentadienyl)ruthenium, hydrido(cyclopentadienyl)(1,5-cyclooctadiene)ruthenium, chloro(cyclopentadienyl)(1,5-cyclooctadiene)ruthenium, tricarbonyl(pentamethylcyclopentadienyl)ruthenium-tetrafluoroborate, ruthenium(acetylacetonate), ruthenium chloride, dichloro(pentamethylcyclopentadienyl)ruthenium, dichloro(pentamethylcyclopentadionyl)(triphenylphosphine)-ruthenium, tetrahydridotris(triphenylphosphine)ruthenium, trichloro(pentamethylcyclopentadienyl)ruthenium, trihydro(pentamethylcyclopentadienyl)(triphenylphosphine) ruthenium, and dichloro(η-allyl)(cyclopentadienyl) ruthenium.

The rhodium compound exemplarily includes rhodium carbon, rhodium alumina, rhodium silica, octacarbonyldirhodium, dodecacarbonyltetrarhodium, rhodium(dicarbonyl)(acetylacetonato), di-µ-chlorotetracarbonyldirhodium, hydridotetracarbonylrhodium, chlorotris(triphenylphosphine)rhodium, tetrakis(trimehtylphosphine)rohdium )rohdium chloride, trans-[chlorocarbonylbis(tricyclohexylphosphine)rhodium], hydridotris(triisopropylphosphine)rhodium, hydridotetrakis(triphenylphosphine)rhodium, hydridotetrakis(triisopropylphosphido)dirhodium, di-µ-chloro-tetra(η-ethylene)dirhodium, di-µ-chlorotetrakis(cyclooctene)dirhodium, di-µ-chlorobis(cyclooctadiene)dirhodium, di-µ-chloro-bis(η-tetraphenylcyclobutadiene)dirhodium, 2,4-pentandionatobis(ethylene)rhodium, bis(cycloocta-1,5-diene)rhodium, 1,5-cyclooctadienebis(acetonitrile)rhodiumtetrafluoro borote, diammine cyclooctadienerhodiumhexafluorophoephate, rhodium acetate, rhodium(acetylacetonate), rhodium chloride, rhodium bromide, di-µ-chlorodichlorobis-(pentamethylcyclopentadienyl)dirhodium, di-µ-carbonyl-bis(pentamethylcyclopentadienyl)dirhodium, tris(acetonitrile)pentamethlcycclopentadienylrhodiumdihexafluorophosphate, (1,4-butandiel)(η-pentamethylcyclopentadienyl)-(triphenylphosphine)rhodium, di-µ-chloro-tetralkis(η-allyl)dirhodium, tris(η-allyl)rhodium, hydridooctaethylporphyrinatorhodium, dimethyl-di-µ-methylenebis(pentamethylecyclopentadienyl)-dirhodium and dihydridobis(triethylsilyl)-pentamethylcyclopentadienylrhodium.

The palladium compound exemplarily includes palladium carbon, palladium alumina, tetrakis(triphenylphosphine)palladium, bis(tricyclohexylphosphine)palladium, tetrakis(triethylphosphido)palladium, carbonyltris(triphenylphosphine)palladium, (η-ethylene)bis(triphenylphosphine)palladium, bis(cycloocta-1,5-diene)palladium, tris(dibenzylideneacetone)dipalladium, dichloro-µ-bis[bis(diphenylphosphino)methane]dipaladium, palladium acetate, palladium(acetylacetonato),palladium chloride, palladium iodide, dichlorobis(benzonitrile)palladium, dichloro(1,5-cyclooctadiene)palladium, dichlorobis(triphenylphosphine)palladium, di-µ-chloro-dichlorobis(isocyanido)dipalladium, di-µ-chloro-dichlobis(tripehnylphosphine)dipalladium, trans-[bis(t-butylisocyanide)dichloropalladium], chloromethyl(1,5-cyclooctadiene)palladium, dimethylbis(triethylphosphine)palladium, trans-[bromo(methyl)bis(triethylphosphine)palladium], trans-chloro(phenylethynyl)bis(tributylphosphine)palladium, cyclopentadienyl(phenyl)(triethylphosphine)palladium, η-allyl(pentamethylcyclopentadienyl)palladium, η-allyl(1,5-cyclooctadiene)palladiumtetrafluoroborate and di-µ-chlorobis(η-allyl)dipalladium.

The iridium compound exemplarily includes dodecacarbonyltetrairidium, hexacarbonylhexairidium, di-µ-chlorotetrakis(cyclooctene)diiridium, di-µ-chlorotetrakis(ethylene)diiridium, di-µ-chlorobis(1,5-cyclooctadiene)diiridium, chlorotris(triphenylphosphine)iridium, chloroethylenebis(triphenylphosphine)iridium, chloroethylenebis(triphenylphoephine)iridium, chloro(dinitrogen)bis(tripenylphosphine)iridium, (pentamethylcyclopentadienyl)dicarbonyliridium, pentamethylcyclopentadienylbis(ethylene)iridium, carbonylhydridetris(triphenylphosphine)iridium, chlorodicarbonyl(p-toluidine)iridium, carbonylmethylbis(triphenylphosphine)iridium, iridium(acetylacetonato), iridium chloride, tris(η-allyl)iridium, di-µ-chlorodichlorobis(pentamethylcyclopentadienyl)diiridium, trichlorotris(triethylphosphine)iridium, dihydrido(pentamethylcyclopentadienyl)-trimethylphosphineiridium and pentahydridobis(trimethylphosphine)iridium.

The platinum compound exemplarily includes platinum carbon, platinum alumina, bis(dibenzilidene acetone)platinum, tris(ethylene)platinum, tetrakis(triphenylphosphine)platinum, tris(triphenylphosphine)platinum, tetrakis(triphenylphosphido)platinum, carbonyltris(tripehnylphosphine)platinum, bis(triphenylphosphine)(diphenylacetylene)platinum, bis(triphenylphosphine)(trans-stilbene)platinum, bis[carbonyl(pentamethylcyclopentadienyl)platinum], µ-[bis-(diphenylphosphino)methane]-bis(chloroplatinum), platinum(acetylacetonato), platinum dichloride, platinum dibromide, cis-bis(benzonityl)dichloroplatinum, cis-dichlorobis(acetonitryl)platinum, trans-dichlorobio(acetonitryl)platinum, dichloro(η-1,5-cyclooctadiene)platinum, cis-dichlorobis(tributylphosphine)platinum, trans-dichlorobis(tributylphosphine)platinum, cis-[dichloro(phenylisocyanide)(triphenylphosphine)platinum], cis-[dichloro(diaminocarbene)(triethylphosphine)platinum], trichloro(η-ethylene)potasssium platinate, di-µ-chloro-dichloro(ethylene)diplatinum, bis(1,5-cyclooctadiene)platinum, trans-hydridechlorobis(triethylphosphine)platinum, dimethyl(1,5-cyclooctadiene)platinum, trans-[iodo(methyl)bis(triethylphosphine)platinum], cis-[chloro(methyl)bis(dimethylphenylphosphine)platinum] dibutylbis(triphenylphosphine)platinum and platinum tetrachloride.

The above exemplified metals or compounds thereof may be used in combination.

An alternative catalyst used in the invention comprises a mixture of the above recited metals or their compounds and a silyl compound (IV). Specific examples of such silyl compound include phenyldimethylsilyllithium, diphenylmethylsilyllithium, t-butyldiphenylsilyllithium, triphenylsilyllithium, tris(trimethylsilyl)silyllithium, trimethylsilylsodium, triethylsilylsodium, tri-n-butylsilylsodium, tri-i-propylsilylsodium, tri-n-butylsilylsodium, tri-n-hexylsilylsodium, triphenylsilylsodium, ethyldimethylsilylsodium, n-propyldimethylsilylsodium, i-propyldimethylsilylsodium, n-butyldimethylsilylsodium, t-butyldimethylsilylsodium, n-hexyldimethlsilylsodium, cyclohexyldimethylsilylsodium, n-octyldimethylsilylsodium, n-decyldimethylsilylsodium, phenyldimethylsilylsodium, benzyldimethylsilylsodium, phenethyldimethylsilylsodium, di-n-butylmethlsilylsodium, diphenylmethylsilylsodium, t-butyldiphenylsilylsodium, tris(trimethylsilyl)silisodium, trimethylsilylpotassium, triethylsilylpotassium, tri-n-propylsilylpotassium, tri-i-propylsilylpotassium, tri-n-butylsilylpotassium, tri-n-hexylsilylpotassium, triphenylsilylpotassium, ethyldimethylsilylpotassium, n-propyldimethylsilylpotassium, i-propyldimethylsilylpotassium, n-butyldimethylsilylpotassium, t-butyldimethylsilylpotassium, n-hexyldimethylsilylpotassium, cyclohexyldimethylsilylpotassium, n-octyldimethylsilylpotassium, n-decyldimethylsilylpotassium, phenyldimethylsilylpotassium, benzyldimthylsilylpotassium, phenethyldimethylsilylpotassium, di-n-butylmethylsilylpotassium, diphenylmethylsilylpotassium, t-butyldiphenylsilylpotassium and tris(trimethylsilyl)silylpotassium. Two or more of these compounds may be used in combination. These silyl compounds may contain a liquid such as ether and tetrahydrofuran.

Another alternative catalyst according to the invention comprises a mixture of the above metals or their compounds and a metal hydride (V). Specific examples of such metal hydride includes, LiH, NaH, KH, CaH₂, AlH₃, MeAlH₂, EtAlH₂, i-PrAlH₂, n-BUAlH₂, i-BuAlH₂, sec-BuAlH₂, t-BUAlH₂, Me₂AlH₂, Et₂AlH, n-Pr₂AlH, i-Pr₂AlH, n-Bu₂AlH, i-Bu₂AlH, sec-Bu₂AlH, t-Bu₂AlH, LiAlH₄, LiAl(Et)₂H₂, LiAl(n-Pr)₂H₂, LiAl(i-Pr)₂H₂, LiAl(n-Bu)₂H₂, LiAl(i-Bu)₂H₂, LiAl(sec-Bu)₂H₂, LiAl(t-Bu)₂H₂, LiAl(Et)₃H, LiAl(n-Pr)₃H, LiAl(i-Pr)₃H, LiAl(n-Bu)₂H, LiAl(i-Bu)₃H, LiAl(sec-Bu)₃H, LiAl(OMe)₃H, LiAl(OEt)₃H, LiAl(O-t-Bu)₃H, NaAl(OCH₂CH₂-OMe)₃H, BH₃, [(CH₃)₂CHCH(CH₃)]₂BH, LiBH₄, LiB(sec-Bu)₃H, LiB(Et)₃H, Li(9-BBN)H, NaBH₄, KBH₄, Me₄NBH₄, Et₄NBH₄, LiD, NaD, KD, CaD₂, AID₃, MeAlD₂, EtAlD₂, n-PrAlD₂, i-PrAlD₂, n-BuAlD₂, i-BuAlD₂, sec-BuAlD₂, t-BuAlD₂, Ne₂AlD, Et₂AlD, n-Pr₂AlD, i-Pr₂AlD, n-Bu₂AlD, i-Bu₂AlD, sec-Bu₂AlD, t-Bu₂AlD, LiAlD₄, LiAl(Et)₂D₂, LiAl(n-Pr)₂D₂, LiAl(i-Pr)₂D₂, LiAl(n-Bu)₂D₂, LiAl(i-Bu)₂D₂, LiAl(sec-Bu)₂D₂, LiAl(t-Bu)₂D₂, LiAl(Et)₃D, LiAl(n-Pr)₃D, LiAl(i-Pr)₃D, LiAl(n-Bu)₃D, LiAl(i-Bu)₃D, LiAl(sec-Bu)₃D, LiAl(OMe)₃D, LiAl(OEt)₃D, LiAl(O-t-Bu)₃D, NaAl(OCH₂CH₂OMe)₃D, BD₃, [(CH₃)₂CHCH(CH₃)]₂BD, LiBD₄, LiB(sec-Bu)₃D, LiB(Et)₃D, Li(9-BBN)D, NaBD₄, KBD₄, Me₄NBD₄ and Et₄NBD₄.

These metal hydrides may be used also singly or in combination.

The metal and/or metal compound specified herein for use as the catalyst should be used in an amount of usually 0.01-10 mols, preferably 0.1-5 mols, per 100 mols of the hydrosilane monomer (I,II, or III). The silyl compound (IV) and the metal hydride (V) also specified herein as the catalyst should be used respectively in an amount of usually 0.005-50 mols, preferably 0.05-20 mols, per 100 mols of the hydrosilane monomer.

The metal and/or metal compound and the silyl compound (IV) should be blended in a molar ratio of usually 1/0.01-1/100, preferably 1/0.1-1/50. The metal and/or metal compound and the metal hydride (V) should be blended in a molar ratio of usually 1/0.01-1/100, preferably 1/0.1-1/50.

The catalysts used in the invention may be added with crown ethers such as 12-crown-4, 15-crown-5, 18-crown-6, dibenzo-12-crown-4, dibenzo-15-crown-5 and dibenzo-18-crown-6, or diamines such as tetramethylethylenediamine. These additives may be used in an amount of usually 0.005-50 mols, preferably 0.05-20 mols per 100 mols of the hydrosilane monomer (I, II or III).

The dehydrogenative condensation reaction for the hydrosilane monomers should be carried out at a temperature of usually 0°-250°C, preferably 25°-210°C, under a pressure of usually 1 mmHg-200 kg/cm², preferably atmospheric -100 kg/cm² and for a time period of usually 5 minutes-24 hours, preferably 30 minutes-3 hours, depending upon the reaction temperature, the amount of the catalyst and the amount of the starting monomer used. The reaction may be effected with or without the use of solvents. These solvents, when desired, may be chosen from the group of hydrocarbon solvents such as toluene, xylene, heptane, decane and dodecane, ether solevents such as diethylether, isopropyl ether, methylbuthyl ether, dimethoxy-ethane, tetrahydrofuran and dioxane, amide solvents such as dimethylformamide and hexamethylphosphoric triamide, ester solvents such as ethylacetate and butylacetate, and sulfoxides such as dimethylsulfoxide.

The order in which the catalyst and the monomer are added is optional; they may be added together or added one after the other.

The reaction according to the invention is conducted preferably in the presence of an inert gas such as argon and nitrogen regardless of the use of solvents.

The resultant condensate may be treated with acids such as hydrochloric acid, sulfuric acid, acetic acid, trifluoro acetate and benzenesulfonic acid, or alternatively refined with use of Florisil (tradename) or by re-precipitation. These processes may also be combined. The condensate may be determined as to its structure by means of infrared or ultraviolet absorption spectrum, nuclear magnetic resonance (such as ¹HNMR, ¹³CNMR and ²⁹SiNMR) and gel permeation chromatography.

The condensate obtained in accordance with the invention usually contains repeating units of the formulae 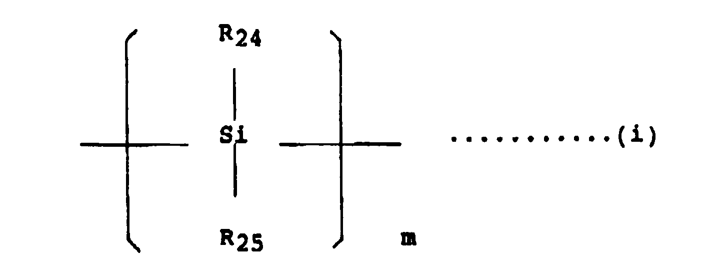 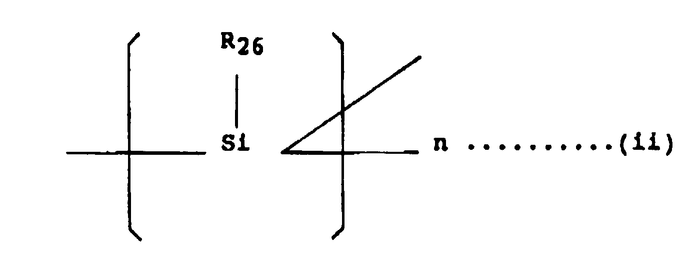 and 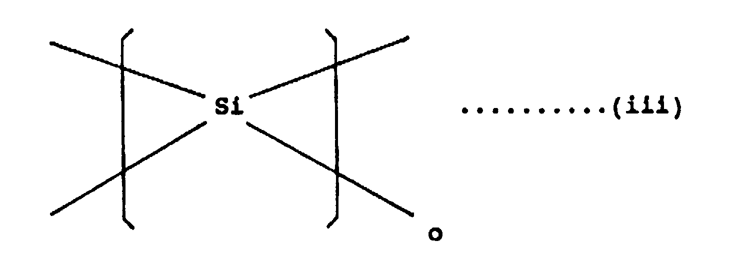 wherein R₂₄, R₂₅ and R₂₆ are identical or different, and each include hydrogen, C₁-C₁₂ alkyl, cycloalkyl and halogenated alkyl groups, C₇-C₁₂ aralkyl and halogenated aralkyl groups, C₆-C₁₂ aryl groups and the silyl groups (formula I'), and may be crosslinked within and between the repeating unit structures. n/m is usually 0-10, preferably 0-5, and o/n is usually 0-10, preferably 0-5.

The repeating units (i), (ii) and (iii) vary in structure with the reaction temperature. They are predominantly straight-chain or monocyclic at a relatively low reaction temperature (usually 0°-60°C), leading to less branched or crosslinked polysilanes which have a polymerization degree of usually 20-100 and a weight average molecular weight (Mw) of usually 100-10,000,000, preferably 500-1,000,000 and a number average molecular weight (Mn) of usually 100-1,000,000, preferably 300-500,000. n/m is usually 0-10, preferably 0-5, and o/n is usually 0-10, preferably 0-5.

The values n and/or o in the above formulae tend to be greater the higher the reaction temperature giving less straight-chain or monocyclic structure usually at 180°-250°C and thus leading to the yield of polysilanes rich in branched crosslinked or polycyclic structure which have a polymerization degree of usually 6-2,000, a weight average molecular weight (Mw) of usually 100-10,000,000, preferably 500-1,000,000 and a number average molecular weight (Mn) of usually 100-1,000,000, preferably 300-500,000. In this instance the values m, n and o may possibly be O and the ranges of n/m and o/n, therefore not exactly predictable, may each be usually 0-1,000, preferably 0-100.

At an intermediate reaction temperature of 60°-180°C, there will be obtained a polysilane having a polymerization degree of usually 10-1,000, a weight average molecular weight (Mw) of usually 100-10,000,000, preferably 500-1,000,000 and a number average molecular weight (Mn) of usually 100-1,000,000, preferably 300-500,000, in which instance the values n/m and o/n each are usually 0-100, preferably 0-20.

The ratios of m, n and o may be adjusted according to the type of the starting hydrosilane feedstock used and the relative amounts of two or more different hydrosilanes that may be used.

The condensate product is subjected to thermal decomposition in which it is dissolved in a suitable solvent such as toluene and tetrahydrofuran and cast over a sheet of quartz or stainless steel, or a silicone wafer. Alternatively, the condensate may be thermally decomposed after it is processed into a fibrous or pellet form. The thermal decomposition is effected in the presence of an inert gas such as argon and nitrogen or in a vacuum of 10⁻⁵-10⁴ pa, preferably 10⁻³-10³ pa and at a temperature of 100°-700°C. It may be effected further in the presence of a reducing gas such as hydrogen, or a vapor such as of iodine, ferric chloride, antimony pentafluoride, antimony pentachloride, arsenic pentafluoride, phosphorous trichloride, borone tribromide and aluminum trichloride. The semiconducting material derived from the inventive process ranges in hue from yellow to dark brown, to glossy silver and has in the case of a film a thickness of usually 0.01 µm-500 µm, preferably 0.1 µm-50 µm, and an optical band-gap (Eo) of usually 0.1-4.0 eV, preferably 0.5-2.0 eV.

The invention will be further described by way of the following examples.

### Example 1

166 mg.(0.437 mmol) of Cp₂HfCl₂ and 369 mg.(0.784 mmol) of (Me₃Si)₃SiLi·THF₃ were placed into a 100 ml glass flask equipped with magnetic stirrer, followed by addition of 5.0 ml (40 mmol) of PhSiH₃. Immediately thereafter, there was a vigorous gas formation, whereupon the reaction product discolored to yellowish brown. The gas generation continued vigorously for about 10 minutes and then grew mild. The admixture was stirred first at 100°C for one hour and then at 200°C for two hours, whereupon the reaction product was dissolved in 500 ml toluene, passsed through a column containing 55 g. of Florisil and removed of toluene to give a yellowish particulate condensate at a yield of 96% by weight in terms of PhSiH₃. The condensate was dissolved in toluene, cast over a sheet of quartz glass and heated at 700°C for one hour in an argon atmosphere. There was obtained a thin dark brown film which exhibited a conducting of 10⁻³ s/cm.

### Example 2

64 mg.(0.17 mmol) of Cp₂HfCl₂, 30 mg.(0.76 mmol) of KH and 249 mg.(0.942 mmol) of 18-crown-6 were put together with 2.5 g.(17 mmol) of n-HexH₂SiSiH₃ and heated at 100°C for one hour and then at 150°C for two hours. The reaction product was refined in a manner similar to Example 1, whereupon there was obtained a reddish brown solid polysilane at a yield of 75% by weight in terms of n-HexH₂SiSiH₃. The resulting condensate was dissolved in toluene, cast over a sheet of quartz glass and heated at 500°C for two hours in an argon atmosphere thereby forming a thin dark brown film which exhibited a conductivity of 10⁻⁵ s/cm.

### Example 3

A 1-liter autoclave equipped with stirrer was charged with 290.7 mg.(0.9945 mol) of dichloro-bis-cyclopentadienyl zirconium, 868.9 mg.(1.845 mmols) of tris-(trimethylsilyl)-silyllithium-3-tetrahydrofuranate, 11.03 g.(110.0 mmols) of cyclopentylsilane, 2.40 g.(74.8 mmols) of silane gas and 141 ml. of toluene. The admixture was stirred at 200°C for 5 hours, followed by addition of 30 ml. of toluene and 10 ml. of trifluoroacetate and then agitation at 80°C for one hour. The reaction mixture was allowed to precipitate in 500 ml. of methanol, with the resulting precipitate filtrated, washed with methanol and vacuum-dried thereby giving 9.64 g. of a yellowish powdery polymer (75% yield in terms of polystyrene; Mw=2,600, Mw/Mn=1.7). The polymer was dissoleved in xylene to make a 10% by weight solution and spin-coated on a 5x5cm quartz substrate, followed by calcination at 600°C for 3 hours in the presence of a flow of argon at 2 l/min. There was obtained a dark brown thin film measuring 0.2 µm thick (by contact stylus method) which had a conductivity of 10⁻⁵ s/cm and an optical band-gap (Eo) of 1.6 eV.

### Example 4

The procedure of Example 3 was followed except that 199.0 mg.(0.7991 mol) of dichloro-bis-cyclopentadienyl-titanium, 875.6 mg.(1.859 mmols) of tris-(trimethylsilyl)-silyllithium-3-tetrahydrofuranate, 9.36 g.(80.5 mmols) of n-hexylsilane and 2.40 g.(74.8 mmols) of silane gas were used. There was obtained a milky white powdery polymer (8.23 g., yield 70%, Mw=15,000, Mw/Mn=3.2 in terms of polystyrene). The polymer was dissolved in xylene to make a 10 wt.% solution which was then applied to a quartz substrate and calcined in a manner similar to Example 3. The resulting film was brown and 0.1 µm thick. Its conductivity was 10⁻⁶ s/cm and its optical band-gap (Eo) was 1.8 eV.

### Example 5

The procedure of Example 3 was followed except that the starting monomer comprised 4.0 g.(34 mmols) of n-hexylsilane and 1.1 g.(35 mmols) of monosilane gas, and the catalyst comprised 196 mg.(0.342 mmol) of bis-(trimethylsilyl)-methyl-bis-(η-pentamethylcyclopentadienyl)-neosium and that the admixture was reacted at 200°C for 24 hours. There was obtained a brown powdery polysilane (3.5 g., yield 69%, Mw=9,800, Mw/Mn=4.4 in terms of polystyrene).

Upon calcination it turned into a brown thin film whose conductivity was 10⁻⁶ s/cm and optical band-gap (Eo) was 2.2 eV.

### Example 6

The procedure of Example 3 was followed except that the catalyst comprised 666 mg.(0.695 mmol) of dichloro-tris-(triphenylphosphine)-ruthenium and 94.4 mg.(2.35 mmols) of hydrogenated potassium. The resulting brown powdery polysilane (3.3 g., yield 65%) was calcined to produce a dark brown film having a conducting of 10⁻⁶ s/cm and an optical band-gap (Eo) of 1.5 eV.

### Example 7

The procedure of Example 1 was followed except that the starting monomer was benzylsilane (4.89 g., 40 mmols) and the catalyst comprised dichloro-bis-(triphenylphosphine)-cobalt(440 mg., 0.673 mmol) and tris-(trimethylsilyl)-silyllithium-3-tetrahydrofuranate (339 mg., 0.722 mmol). The resulting yellowish powdery polysilane (3.4 g., yield 70%) was calcined to produce a brown thin film having a conductivity of 10⁻³ s/cm.

### Example 8

The procedure of Example 1 was followed except for the use of alpha-phenethyldisilane (6.65 g., 40 mmols) as the starting monomer and hydridecarbonyl-tris-(triphenylphosphine)-rhodium (573 mg., 0.624 mmol) as the catalyst. There was obtained a brown powdery polysilane (5.4 g., yield 82%), which upon calcination formed a brown thin film having a conductivity of 10⁻² s/cm.

### Example 9

The procedure of Example 1 was followed except for the use of β-phenethyldisilane (6.65 g., 40 mmols) as the starting monomer and a mixture of chlorocarbonyl-bis-(triphenylphosphine)-iridium (550 mg., 0.705 mmol) and tris-(trimethylsilyl)-silyllithium-3-tetrahydrofuranate (339 mg., 0.722 mmol). The resulting light yellow powdery polysilane (3.5 g., yield 52%) was calcined to produce a brown thin film having a conductivity of 10⁻⁶ s/cm.

### Example 10

The procedure of Example 1 was followed except that the starting monomer 1,3-di-n-hexyltrisilane (2.08 g., 8.0 mmol) was reacted in the presence of a catalyst comprising dichloro-bis-(triphenylphosphine)-nickel (90 mg., 0.138 mmol), hydrogenated potassium (12 mg., 0.29 mmol) and 18-crown-6 (27 mg., 0.101 mmol). There was obtained a light yellow powdery polysilane (1.51 g, yield 73%) having a conductivity of 10⁻¹ s/cm.

### Example 11

The procedure of Example 1 was followed except for the use of benzyldisilane (2.03 g., 13 mmol) as the starting monomer and a mixture of dichloro-bis-(triphenylphosphine)palladium (150 mg., 0.230 mmol) and tris-(trimethylsilyl)-silyllithium-3-tetrahydrofuranate (218 mg., 0.463 mmol) as the catalyst. The resulting light yellow powdery polysilane(0.71 g., yield 35%) had a conductivity of 10⁻² s/cm.

### Example 12

The procedure of Example 1 was followed except for the use of cyclohexylsilane (4.57 g., 40 mmols) as the starting monomer and cis-dichloro-bis-(triphenylphosphine)-platinum (541 mg., 0.684 mmol) as the catalyst. There was obtained a brown powdery polysilane (3.66 g., yield 80%) which upon calcination exhibited a conductivity of 10⁻⁶ s/cm.

## Claims

1. A method of producing a semiconducting material which is characterized by subjecting to hydrogenative condensation one or more hydrosilanes of the group consisting of :
a hydromonosilane of the formula 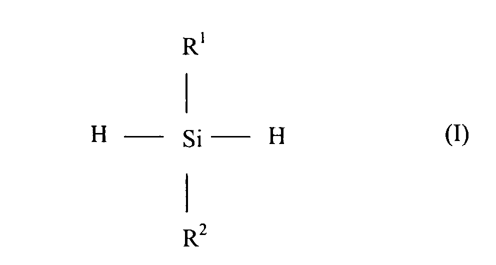 wherein R¹ and R² are independently selected from the group consisting of a hydrogen atom and alkyl, cycloalkyl and halogenated alkyl groups having from 1 to 12 carbon atoms, aralkyl groups and halogenated aralkyl groups having from 7 to 12 carbon atoms, aryl groups having 6 to 12 carbon atoms and silyl groups having the formula:
R³ R⁴ R⁵ Si- (I')
wherein R³, R⁴ and R⁵ are independently selected from the group consisting of alkyl groups having up to 8 carbon atoms and aryl groups having from 6 to 10 carbon atoms, a hydrodisilane of the formula: 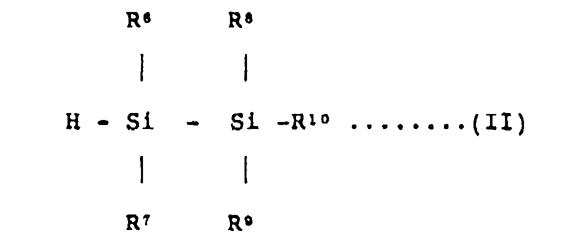 characterized in that R⁶-R¹⁰ are identical or different and include hydrogen, C₁-C₁₂ alkyl, cycloalkyl and halogenated alkyl groups, C₇-C₁₂ aralkyl and halogenated aralkyl groups, C₆-C₁₂ aryl groups, and silyl groups of the formula (I'), either one of R⁶-R¹⁰ being invariably hydrogen, and a hydrotrisilane of the formula 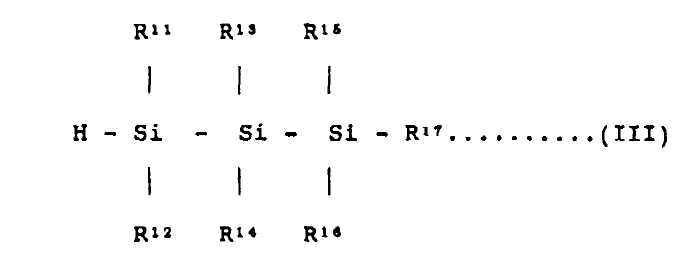 characterized in that R¹¹-R¹⁷ are identical or different and include hydrogen, C₁-C₁₂ alkyl, cycloalkyl and halogenated alkyl groups, C₇-C₁₂ aralkyl and halogenated aralkyl, C₆-C₁₂ aryl groups, and silyl groups of the formula (I'), either one of R¹¹-R¹⁷ being invariably hydrogen, in the presence of a catalyst comprising at least one of the metals and/or metal compounds of groups 3B to 7B and 8 of the Periodic Table, and thermally decomposing said condensate at a temperature of 100 to 700 degrees Celsius.

2. The method according to claim 1, characterized in that said catalyst is combined with a silyl compound of the formula:
R¹⁸R¹⁹R²⁰SiA (IV)
wherein R¹⁸, R¹⁹ and R²⁰ are identical or different and include alkyl groups having from 1 to 12 carbon atoms, aralkyl groups having from 7 to 12 carbon atoms, aryl groups having 6 to 12 carbon atoms and silyl groups of the formula (I'), and A is a lithium, sodium or potassium atom.

3. The method according to claim 1, characterized in that said catalyst is combined with a metal hydride of the formula:
A' Xn (V)
wherein A' is a lithium, sodium, potassium, calcium or aluminium atom, R²¹₍₃₋ₙ₎Al, LiAl, LiA;R²²₍₄₋ₙ₎' NaAlR²²₍₄₋ₙ₎, B, R²¹₍₃₋ₙ₎B, LiB, LiBR²², NaB, KB and R²³B, R²¹ is an alkyl group having 1 to 5 carbon atoms, R²² is an alkyl group or alkoxy group having from 1 to 8 carbon atoms, R²³ is a hydrogen atom or a quaternary ammonium group having 1 to 4 carbon atoms, X is protium or deuterium and n is an integer from 1 to 4, and R²¹, R²² and R²³ may be different when n is 1 to 3.

4. The method according to any of the preceding claims, characterized in that said catalyst is used in an amount of 0.01 to 10 mols per 100 mole of said hydrosilane monomer.

5. The method according to any of the preceding claims, characterized in that each of said silyl compounds and said metal hydrides is used in an amount of 0.005 to 50 mols per 100 mole of said hydrosilane monomer.

6. The method according to any of the preceding claims, characterized in that said condensate is thermally decomposed in an inert gas atmosphere or in a vacuum of 10⁻⁵ to 10⁴ Pa.

7. The method according to any of the preceding claims, characterized in that said semiconducting material formed from said thermally decomposed condensate has an optical band gap (Eo) in the range 0.1 to 2.2 eV.

## Patentansprüche

1. Verfahren zur Herstellung eines halbleitenden Materials, **dadurch gekennzeichnet,** daß einer hydrogenisierenden Kondensation unterzogen werden ein oder mehrere Hydrosilane der Gruppe bestehend aus:
einem Hydromonosilan der Formel 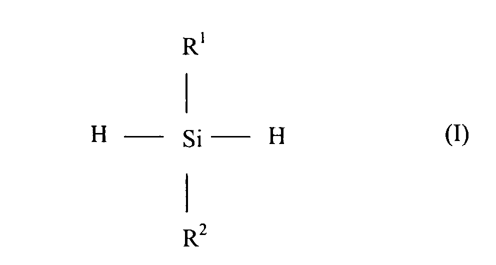 wobei R¹ und R² unabhängig ausgewählt werden aus der Gruppe bestehend aus einem Wasserstoffatom und Alkyl, Cycloalkyl und halogenierten Alkylgruppen mit 1 bis 12 Kohlenstoffatomen, Aralkylgruppen und halogenierten Aralkylgruppen mit 7 bis 12 Kohlenstoffatomen, Arylgruppen mit 6 bis 12 Kohlenstoffatomen und Silylgruppen nach der Formel:
R³R⁴R⁵ Si- (I')
wobei R³, R⁴ und R⁵ unabhängig ausgewählt werden aus der Gruppe bestehend aus Alkylgruppen mit bis zu 8 Kohlenstoffatomen, und Arylgruppen mit 6 bis 10 Kohlenstoffatomen,
einem Hydrodisilan der Formel 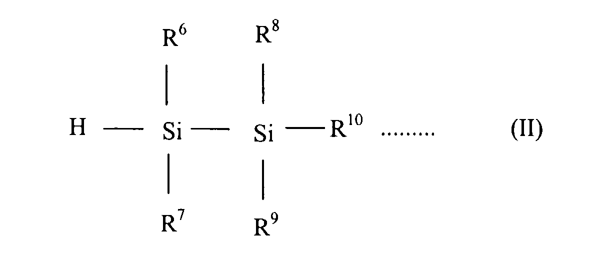 dadurch gekennzeichnet, daß R⁶ - R¹⁰ identisch oder verschieden sind und beinhalten Wasserstoff, C₁ - C₁₂ Alkyl, Cycloalkyl und halogenierte Alkylgruppen, C₇- C₁₂ Aralkyl und halogenierte Aralkylgruppen, C₆ - C₁₂ Arylgruppen, und Silylgruppen der Formel (I'), eines der R⁶-R¹⁰ ausnahmslos Wasserstoff ist,
und einem Hydrotrisilan der Formel 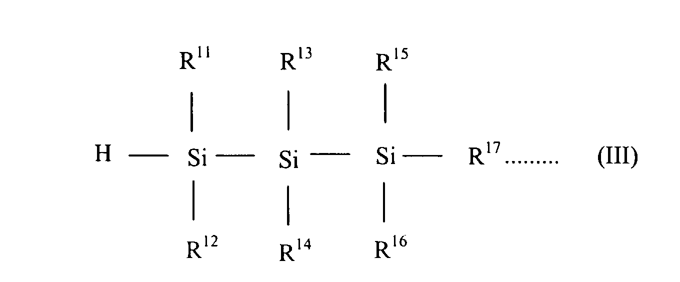 dadurch gekennzeichnet, daß R¹¹ - R¹⁷ identisch oder verschieden sind und beinhalten Wasserstoff, C₁ - C₁₂ Alkyl, Cycloalkyl und halogenierte Alkylgruppen, C₇- C₁₂ Aralkyl und halogenierte Aralkylgruppen, C₆ - C₁₂ Arylgruppen, und Silylgruppen der Formel (I'), und eines der R¹¹-R¹⁷ ausnahmslos Wasserstoff ist,
in der Gegenwart eines Katalysators der mindestens eines der Metalle und/oder Metallverbindungen der Gruppen 3B bis 7B und 8 des Periodensystems der Elemente enthält, und das besagte Kondensat thermisch bei einer Temperatur zwischen 100 und 700 Grad Celsius in seine Bestandteile zerlegt.

2. Verfahren nach Anspruch 1, **dadurch gekennzeichnet,** daß der Katalysator kombiniert wird mit einer Silylverbindung der Formel
R¹⁸ R¹⁹ R²⁰ Si A (IV)
wobei R¹⁸, R¹⁹ und R²⁰ identisch oder verschieden sind und beeinhalten Alkylgruppen mit 1 bis 12 Kohlenstoffatomen, Aralkylgruppen mit 7 bis 12 Kohlenstoffatomen, Arylgruppen mit 6 bis 12 Kohlenstoffatomen und Silylgruppen der Formel (I'), und A ein Lithium-, Natrium- oder Kalium-Atom bezeichnet.

3. Verfahren nach Anspruch 1, **dadurch gekennzeichnet,** daß der Katalysator kombiniert wird mit einem Metallhydrid der Formel
A' Xn (V)
wobei A' ein Lithium-, Natrium-, Kalium-, Calcium- oder Aluminium-Atom bezeichnet, R²¹₍₃₋ₙ₎Al, LiAl, LiA;R²²₍₄₋ₙ₎, NaAl R²²₍₄₋ₙ₎, B, R²¹₍₃₋ₙ₎B, LiB, LiBR²² , NaB, KB und R²³B, R²¹ eine Alkylgruppe mit 1 bis 5 Kohlenstoffatomen ist, R²² eine Alkylgruppe oder eine Alkoxygruppe mit 1 bis 8 Kohlenstoffatomen ist, R²³ ein Wasserstoffatom oder eine quaternäre Ammoniumgruppe mit 1 bis 4 Kohlenstoffatomen ist, X Protium oder Deuterium bezeichnet und n ganzzahlig von 1 bis 4 ist, und R²¹, R²² und R²³ unterschiedlich sein können, falls n eine Zahl von 1 bis 3 ist.

4. Verfahren nach einem der voranstehenden Ansprüche, **dadurch gekennzeichnet,** daß der Katalysator in einer Konzentration von 0.01 bis 10 mol pro 100 mol des genannten Hydrosilanmonomers verwendet wird.

5. Verfahren nach einem der voranstehenden Ansprüche, **dadurch gekennzeichnet,** daß jede der genannten Silylverbindungen und der genannten Metallhydride in einer Konzentration von 0.005 bis 50 mol pro 100 mol des genannten Hydrosilanmonomers verwendet wird.

6. Verfahren nach einem der voranstehenden Ansprüche, **dadurch gekennzeichnet,** daß das genannte Kondensat in einer Inertgasatmosphäre oder unter Vakuum von 10⁻⁵ bis 10⁴ Pa thermisch in seine Bestandteile zerlegt wird.

7. Verfahren nach einem der voranstehenden Ansprüche, **dadurch gekennzeichnet,** daß das genannte halbleitende Material, welches aus dem genannten thermisch zersetzten Kondensat gebildet wird, eine optische Bandlücke (E₀) im Bereich von 0.1 bis 2.2 eV aufweist.

## Revendications

1. Procédé de production d'un matériau semiconducteur qui est caractérisé en ce que l'on soumet à une condensation avec hydrogénation un ou plusieurs hydrosilanes faisant partie du groupe constitué par :
un hydromonosilane de formule : 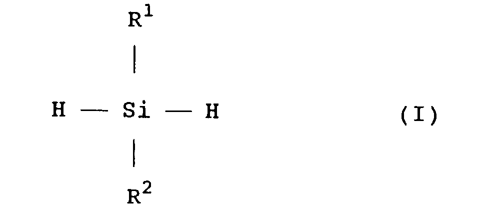 dans laquelle R¹ et R² sont, indépendamment, choisis dans le groupe constitué par un atome d'hydrogène et des groupes alkyles, cycloalkyles et halogéno alkyles comportant de 1 à 12 atomes de carbone, des groupes aralkyles et des groupes halogéno aralkyles comportant de 7 à 12 atomes de carbone, des groupes aryles comportant de 6 à 12 atomes de carbone, et des groupes silyles répondant à la formule :
R³ R⁴ R⁵ Si- (I')
dans laquelle R³, R⁴ et R⁵ sont, indépendamment, choisis dans le groupe constitué par des groupes alkyles comportant jusqu'à 8 atomes de carbone et des groupes aryles comportant de 6 à 10 atomes de carbone,
un hydrodisilane de formule : 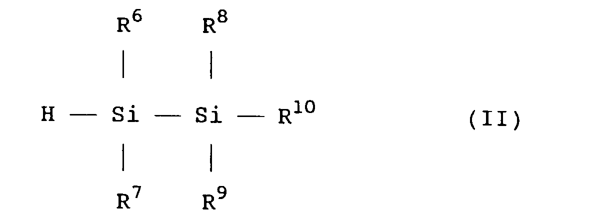 caractérisé en ce que R⁶ à R¹⁰ sont identiques ou différents et englobent un atome d'hydrogène, des groupes alkyles en C₁-C₁₂, cycloalkyles et halogéno alkyles, des groupes aralkyles en C₇₋₁₂, et halogéno aralkyles, des groupes aryles en C₆₋₁₂, et des groupes silyles répondant à la formule (I'), un quelconque de R⁶ à R¹⁰ représentant invariablement un atome d'hydrogène, et
un hydrotrisilane de formule : 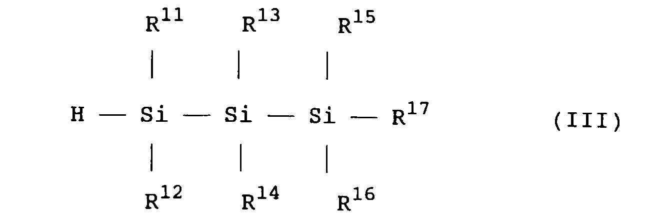 caractérisé en ce que R¹¹ à R¹⁷ sont identiques ou différents et englobent un atome d'hydrogène, des groupes alkyles en C₁₋₁₂, cycloalkyles et halogéno alkyles, des groupes aralkyles en C₇₋₁₂ et halogéno aralkyles, des groupes aryles en C₆₋₁₂, et des groupes silyles répondant à la formule (I'), un quelconque des symboles R¹¹ à R¹⁷ représentant invariablement un atome d'hydrogène, en présence d'un catalyseur comprenant au moins un des métaux et/ou des composés de métaux des groupes 3B à 7B et 8 de la classification périodique des éléments, et à décomposer thermiquement ledit produit de condensation à une température de 100 à 700 degrès Celsius.

2. Procédé selon la revendication 1, caractérisé en ce que ledit catalyseur est combiné avec un composé silylique de formule :
R¹⁸R¹⁹R²⁰SiA (IV)
dans laquelle R¹⁸, R¹⁹ et R²⁰ sont identiques ou différents et englobent des groupes alkyles comportant de 1 à 12 atomes de carbone, des groupes aralkyles comportant de 7 à 12 atomes de carbone, des groupes aryles comportant de 6 à 12 atomes de carbone, et des groupes silyles répondant à la formule (I'), et A représente un atome de lithium, de sodium ou de potassium.

3. Procédé selon la revendication 1, caractérisé en ce que ledit catalyseur est combiné avec un hydrure de métal alcalin de formule :
A'Xₙ (V)
dans laquelle A' représente un atome de lithium, de sodium de potassium, de calcium ou d'aluminium, R²¹₍₃₋ₙ₎Al, LiAl, LiA ; R²²₍₄₋ₙ), NaAlR²²₍₄₋ₙ₎, B, R²¹₍₃₋ₙ)B, LiB, LiBR²², NaB, KB et R²³B, R²¹ représente un groupe alkyle comportant 1 à 5 atomes de carbone, R²² représente un groupe alkyle ou alcoxy comportant 1 à 8 atomes de carbone, R²³ représente un atome d'hydrogène ou un groupe ammonium quaternaire comportant 1 à 4 atomes de carbone, X représente un atome de protium ou de deutérium et n représente un nombre entier de 1 à 4, et R²¹, R²² et R²³ peuvent être différents quand n est de 1 à 3.

4. Procédé selon l'une quelconque des revendications précédentes, caractérisé en ce que l'on utilise ledit catalyseur en une quantité de 0,01 à 10 moles pour 100 moles dudit monomère de type hydrosilane.

5. Procédé selon l'une quelconque des revendications précédentes, caractérisé en ce que l'on utilise chacun desdits composés silyliques et desdits hydrures de métaux, en une quantité de 0,005 à 50 moles pour 100 moles dudit monomère de type hydrosilane.

6. Procédé selon l'une quelconque des revendications précédentes caractérisé en ce que l'on décompose thermiquement ledit produit de condensation dans une atmosphère gazeuse inerte ou sous un vide de 10⁻⁵ à 10⁴ Pa.

7. Procédé selon l'une quelconque des revendications précédentes, caractérisé en ce que ledit matériau semi-conducteur, formé à partir dudit produit de condensation décomposé thermiquement, présente une largeur de bande optique interdite (Eo) située dans l'intervalle de 0,1 à 2,2 eV.
